Europäisches Patentamt

European Patent Office

Office européen des brevets

(11) Publication number: **0 449 285 A2**

## (12) EUROPEAN PATENT APPLICATION

(21) Application number: **91104982.3**

(22) Date of filing: **28.03.91**

(51) Int. Cl.⁵: **H01L 33/00, H05K 3/30, H05K 7/12**

(30) Priority: **30.03.90 DE 4010204**
**16.11.90 DE 4036541**

(43) Date of publication of application:
**02.10.91 Bulletin 91/40**

(84) Designated Contracting States:
**DE FR GB IT SE**

(71) Applicant: **THOMAS & BETTS CORPORATION**
**1001 Frontier Road**
**Bridgewater New Jersey 08807(US)**

(72) Inventor: **Pfeifer, Hans-Dieter**
**Knodenerkopfstrasse 36**
**W-6147 Lautertal 1(DE)**
Inventor: **Pusch, Reinhard**
**Frankfurter Strasse 88**
**W-6054 Rodgau 3(DE)**

(74) Representative: **Berkenfeld, Helmut, Dipl.-Ing.**
**An der Schanz 2**
**W-5000 Köln 60(DE)**

(54) Holding and connecting device for a light emitting diode.

(57) The invention relates to a mounting of light emitting diodes such as in the instrument panel of a motor vehicle. The light emitting diodes should be exchangeable and mounted such that light emitting diodes having different colours can be inserted into a housing only in one rotary position. For this pur-pose, the light emitting diodes are inserted into the housing together with their holders and are con-nected thereto. The diode holders have coding bars. These permit insertion into an opening of a printed circuit bar only in one rotary position.

FIG.4

The invention relates to a holding and connecting device for a light emitting diode (LED) for use thereof for illuminating for example a diffuser screen provided with a symbol, comprising a diode holder with a reflection surface, a light emitting diode with connecting wires, and contacts for mechanical and electrical connection thereof to a printed circuit board.

The instrument panel of a modern motor vehicle also includes a row of lights or a display. The display contains numerous symbols for displaying various operating conditions of the motor vehicle, the setting of the electrical lighting, the contents of the tank and so forth. The symbols more specifically comprise a diffuser screen representing the symbol, with a light source which lights the diffuser screen from behind. In that context the reference to behind means from the side of the diffuser screen which is remote from the driver. The state of the art provides for using small incandescent lamps as the light sources. Even when operated at reduced voltage, the service life of those incandescent lamps is far shorter than the service life of the vehicle. They therefore have to be replaced on a number of occasions during the service life of a vehicle. In particular many incandescent lamps fail during the first hours of operation and thus within the warranty time. As the incandescent lamps can only be reached with some difficulty and after the removal of other components, the operation of replacing same is a highly annoying and expensive one. Luminescence diodes have been known for some time as signalling lamps and for the homogenous illumination of surfaces. They are also referred to as LEDs. For the sake of simplicity of the description, the term light emitting diodes is used hereinafter. Such light emitting diodes emit light over a large angle, with a light flux which is almost constant over the entire angle. They have a low level of power consumption and their service life is very high. By using them in conjunction with a reflection surface, it is possible to influence their light emission, for example on to a diffuser screen. Such light emitting diodes can also emit light in different colours.

The invention is based on the realisation that such light emitting diodes are also highly suitable for illuminating the abovementioned displays in motor vehicles and can advantageously replace the incandescent lamps which were used hitherto. More specifically the object of the invention is that of so designing a holding and connecting device for such a light emitting diode that the light emitting diode can be very easily fitted into the printed circuit board which forms part of such a display or row of lights. In that connection, the invention seeks to provide that the light emitting diode is to be easy to fit not only upon first assembly, but can also be readily replaced during the operating life of the motor vehicle. Finally the invention seeks to provide that the option is still kept available for using light emitting diodes of different colours so that a light emitting diode of a given colour can be fitted to the printed circuit board only at the location intended for that colour.

In accordance with the invention, in a holding and connecting device of the kind set forth in the opening part of this specification, that object is attained in that there is provided a housing, the light emitting diode is fitted into and connected to same, the contacts are arranged on two mutually oppositely disposed sides of the housing, and the diode holder is connected to the housing and can be fitted into an opening in the printed circuit board and on its outward side has a coding bar which permits the diode holder to be fitted into the opening only in one rotary position of the diode holder. The invention provides a housing for accommodating the small light emitting diodes which are therefore difficult to handle and also sensitive. The housing encloses a light emitting diode. In that way, it is easier to handle. The housing also affords the means for arranging the contacts. They then serve for the purposes of mechanical and electrical connection to the printed circuit board. A diode holder is associated with each light emitting diode. A diode holder with a given coding bar is associated with a given light emitting diode. That ensures that the housing with the light emitting diode and the diode holder can only be fitted into the opening in a printed circuit board, in one given rotary position. The respective light emitting diode is associated with that opening. That provides that a light emitting diode of a given colour can only be fitted into the openings which are provided therefor.

The light emitting diodes are manufactured in the form of mass produced articles for many uses. It may happen that a light emitting diode has an operating voltage which is below the operating voltage of the vehicle. To cater for such situations, the invention provides that a resistor is inserted between the light emitting diode and one of the contacts. The resistor reduces the voltage which is supplied to the light emitting diode.

It has been stated that the contacts mechanically connect the housing and therewith also the light emitting diode to the printed circuit board and electrically connect the light emitting diode to the printed circuit board. For that purpose it is provided that the contacts each have a contact bar which extends on the outside of the housing and from each of which two contact legs project outwardly at a spacing from each other and the spacing between each two contact legs corresponds to the thickness of the printed circuit board. Such a contact is associated with each connection or connecting wire of the light emitting diode. Each contact has two contact legs. In the installed condition they bear against the printed circuit board resiliently on the front and rear sides thereof. In that situation, at least one contact leg of each contact is in contact with a conductor track, thereby making the electrical connection.

More specifically it is provided that the contacts comprise a resilient material and the contact legs are stamped and bent out of a contact bar at a spacing from each other. Each contact is thus stamped and bent out of a piece of sheet meatal. In that case, each contact bar desirably also has an opening. Limb portions corresponding to the openings are provided on the outward side of the housing. The limb portions are disposed in a close fit in the openings. That provides that the contacts are fixed on the outside of the housing.

The housing desirably has an aperture for receiving the resistor. Orifices extend between the aperture and the adjacent outward side of the housing. Air reaches the resistor by way of the apertures and cools it.

In a further advantageous construction it is provided that the aperture is disposed at a spacing from the end wall of the housing, which is remote from the diode holder, a slot is provided on the outwand side of said end wall and the orifices extend between the slot and the aperture. The slot facilitates the flow of air into the orifices and thus to the resistor. A screwdriver can likewise be fitted into the slot and the housing can be easily turned with the screwdriver. After having been introduced into the opening in the printed circuit board, the housing can then be easily turned into its operative position.

It has been stated that in an advantageous construction a resistor is disposed between the light emitting diode and the contacts. More specifically it is provided that the two connecting wires of the light emitting diode are connected to a contact bar and a connecting wire of the resistor. The resistor connecting wire which remains free is then connected to the contact bar of the other contact. The connections between the connecting wires of the light emitting diode and the resistor on the one hand and the contact bar on the other hand may be soldered or welded connections.

There are light emitting diodes which produce an uneven strength of light over their periphery. In other words, they shine more brightly upwardly for example than downwardly. That means that they should be fitted into the housing only in a specific rotary position. That ensures that the desired distribution of light obtains on the symbol which is lit by the light emitting diode. For that purpose, in an advantageous construction, the invention provides that disposed in the housing is an aperture which extends in the longitudinal direction thereof for accommodating the connecting wires of the light emitting diode, and the shape of which is so matched to that of the connecting wires that the light emitting diode can be fitted into the housing only in one position. In that connection, it is to be assumed that the manufacturers of the light emitting diodes bend the connecting wires thereof into a specific shape. In that way it is possible to look at the shape of the connecting wires to see what for example is up and down, in relation to the light emitting diode. The light emitting diodes transmit current only in one direction. They are operated with dc voltage. For that purpose they must be installed in the proper position. To achieve that, in the state of the art it has been deemed sufficient for the connecting wires of a light emitting diode to be of different lengths. The polarity of the light emitting diode could be ascertained by referring to the different lengths of the connecting wires. Nonetheless that did not prevent the light emitting diode from being fitted into its housing in the wrong rotary position. Fitment in the correct position is guaranteed by one or both connecting wires being bent in accordance with the invention, and by the housing and the aperture thereof being matched to the shape of the connecting wires. Bending of one or both connecting wires, and the corresponding shaping of the aperture or apertures, only permits the diode to be fitted in the proper position.

Another advantageous configuration provides that arranged on the outward side of the diode holder and extending in the longitudinal direction thereof are bar portions which are aligned with the contact legs. The bar portions extend in pairs. Each two bar portions are associated with a respective contact leg. The bar portions protect the contact legs from unintentional contact. That avoids damage to the contact legs.

Provided in the opening in the printed circuit board, for accommodating the diode holder, are recesses which are aligned with said bar portions and which accommodate same. When the diode holder is fitted into the printed circuit board, the recesses guide the bar portions and therewith the diode holder together with the housing and the light emitting diode.

For the purposes of fixing the housing with the light emitting diode and the diode holder in the opening in the printed circuit board, the housing is pushed into the opening in a given rotary position and then turned. In that operation, a resilient retaining projection provided on the end of the housing which is towards the printed circuit board prevents excessive rotary movement.

There are light emitting diodes of different colours. It has been stated that a light emitting diode of a given colour is only to be fitted into an opening which is intended for same. In order to guarantee that, an advantageous configuration provides that a mounting opening is provided at a given location at the edge of the opening in the printed circuit board, which accommodates the diode holder, the given location is associated with a given colour in respect of a light emitting diode, and the position of the coding bar on the outward side of the diode holder is associated with the same colour and corresponds to the position of the mounting opening. That means that the housing with the diode and the diode holder can be fitted into the opening only in a given rotary position as it is only then that the coding bar is in front of the mounting opening and can be pushed into same.

Desirably the housing of a light emitting diode is coloured in accordance with the colour thereof. That means that it is already easily possible from afar to recognise the colour of the light emitting diode, by virtue of the colouring of the housing.

The diode holder is connected to the housing in any fashion. Desirably, retaining hooks are provided on the end of the diode holder which is towards the housing, and recesses for accommodating the retaining hooks are provided in the housing. The retaining hooks and the recesses should be of different widths. That means that a retaining hook only fits into a specific recess. In that way a retaining hook can be associated with a given side of the diode holder and thus the diode holder can only be fitted into and secured to the housing, in a given rotary position.

In order to improve the light output, in an advantageous configuration the reflection surface is coated to provide a high mirror finish. It is likewise possible to provide reflection surfaces of different shapes. In that way the light is distributed in the desired manner over the symbol on the diffuser screen.

The invention will now be further described with reference to the example of the embodiment illustrated in the drawing in which:

Figure 1   is a perspective view of the housing with inserted diode holder and light emitting diode and the printed circuit board prior to assembly of the housing in the latter,

Figure 2   is a perspective view of the above-indicated components after assembly in the printed circuit board, the arrow indicating the direction of rotation of the housing in the assembly operation,

Figure 3   is a partly sectional side view of the components shown in Figure 2 and a hood with a diffuser screen, which is to be fitted on to the diode holder,

Figure 4   is a view in longitudinal section through the housing with inserted diode holder and diode,

Figure 5   is an end view in the direction indicated by the arrow V in Figure 4,

Figure 6   is an end view in the direction indicated by the arrow VI in Figure 4,

Figure 7   is a view on to the housing with inserted diode holder viewing in the directing indicated by the arrow VII in Figure 4,

Figure 8   is an exploded view of the resistor and two contact bars showing the fixing of the connecting wires of the resistor and the light emitting diode to the contact bars,

Figure 9   is a perspective view of a contact,

Figure 10   is an exploded side view partly in section of the housing, the diode holder and a light emitting diode, and

Figure 11   is a view from above in the direction indicated by the line XI - XI in Figure 10.

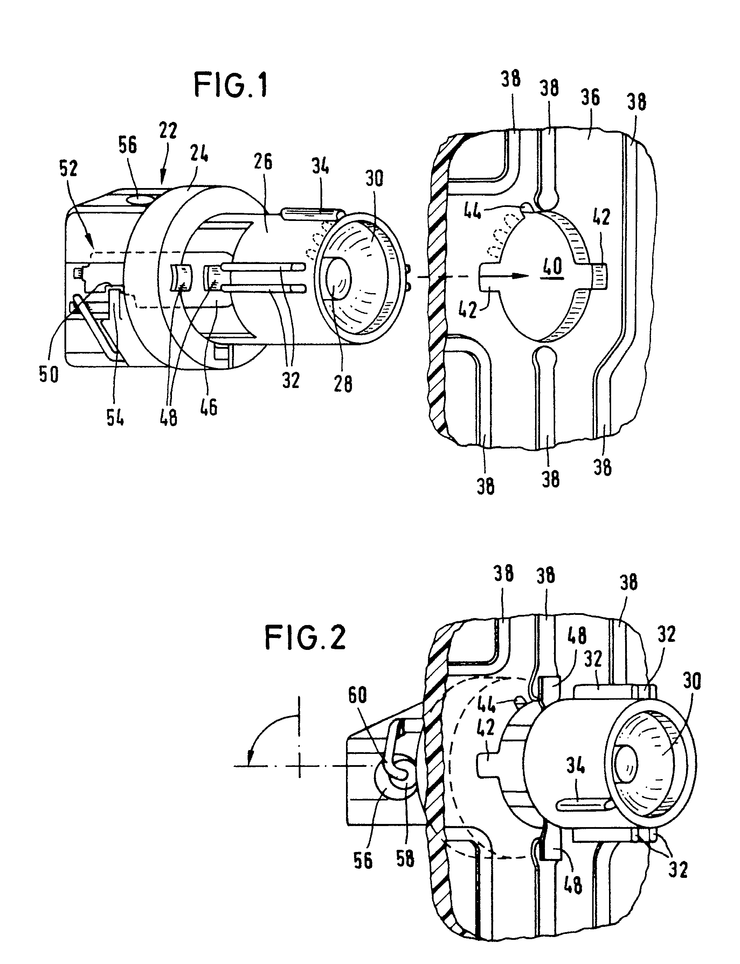

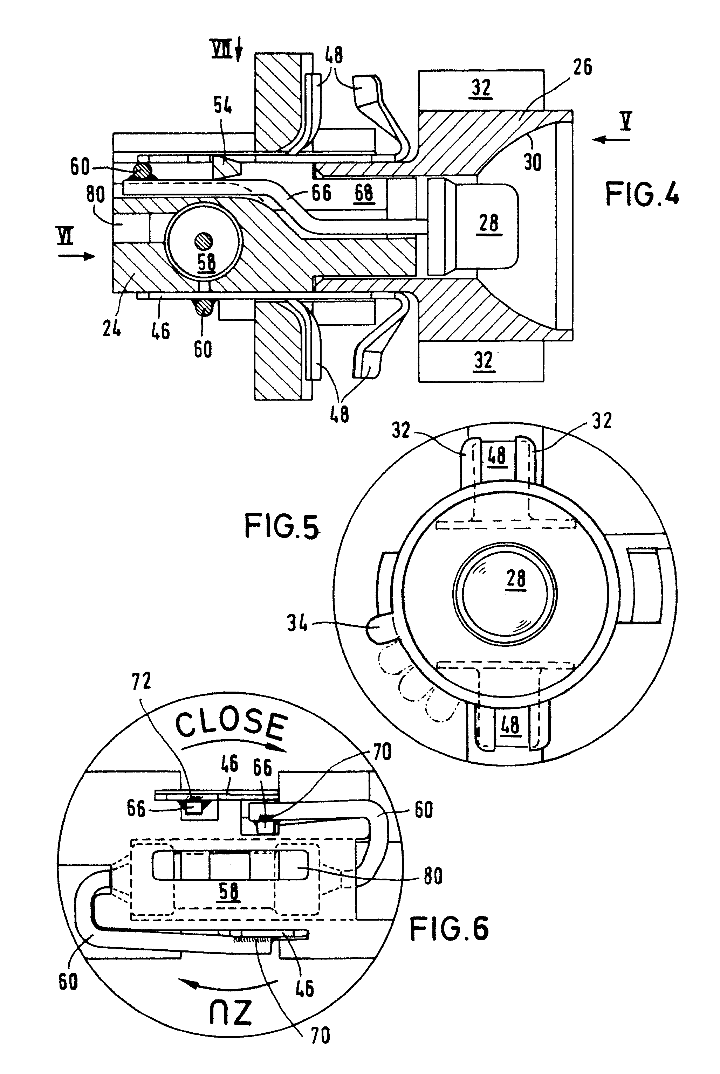

Figure 1 shows the holding and connecting device 22 comprising the housing 24, the diode holder 26 and the light emitting diode 28. The diode holder 26 has a reflection surface 30 on its inside wall which is towards the light emitting diode 28. On its outside wall, at each of two mutually oppositely disposed locations, it has respective pairs of longitudinally extending bar portions 32. A coding bar 34 is also disposed on the outside wall. A coding bar is shown in its entirety in Figure 1. Three further coding bares which are at different rotary positions are indicated. Figure 1 further shows a portion of a printed circuit board 36 which, on its front side, has conductor tracks 38. The conductor tracks may also be arranged on the rear side of the printed circuit board 36. An opening 40 is provided in the printed circuit board 36. At two locations which are 180° apart, the opening 40 has recesses 42, the width and position of which are matched to the spacing between each two bar portions 32 and the position thereof. Mounting openings 44 are provided in the edge of the opening 40. A mounting opening 44, the position of which corresponds to that of the coding bar 34, is shown in its entirety. Three further mounting openings are indicated. Two contact bars 46 extend on the outward side of the housing 24. The contact bar 46 which is towards the viewer can be seen in Figure 1. Each contact bar 46 has two contact legs 48 and an opening 50. A contact bar 46, in conjunction with two contact legs 48 and an opening 50, forms a contact 52. Two limb portions 54 are arranged on the outward side of the housing. One of the limb portions 54 can be seen in Figure 1. It is disposed in an opening 50. In that way, the contact 52 is fixed in its desired position. The housing 24 further has an aperture 56 which accommodates a resistor 58. The resistor 58 has two connecting wires 60 (Figures 2 and 6).

After the foregoing detailed description, the operation of mounting the housing 24 with the diode holder 26 and the light emitting diode 28 in the printed circuit board 36 can now be described. The housing 24 occupies the position shown in Figure 1. The two bar portions 32 on its front and rear side are aligned with the recesses 42 in the printed circuit board 36. When using a light emitting diode 28 which emits light of the correct colour, the coding bar 34 is then also aligned with respect to the mounting opening 44. The diode holder 26, with its coding bar 34, is then associated with the position of the mounting opening 44. The housing 24 is now moved towards the printed circuit board 36 in the direction indicated by the arrow. When that happens, the diode holder 26 is moved into the opening 40. Finally, the contact legs 48 which are at the left in Figure 1 come to bear against the side of the printed circuit board 36, which is behind the plane of the drawing. Thereupon, the housing 24 is turned in the direction indicated by the arrow shown in Figure 2. The contact legs 48 move into the position shown in Figure 2 and they now bear against conductor tracks 38. The resiliency of the contact legs 48 which now bear against both sides of the printed circuit board 36 results in a firm mechanical connection. A good electrical connection is formed by the direct contact between the contact legs 48 and the conductor tracks 38. Figures 1 and 2 further show that the bar portions 32 prevent the printed circuit board 36 or other parts from bearing directly against the contact legs 48. In that way, they are protected from being bent.

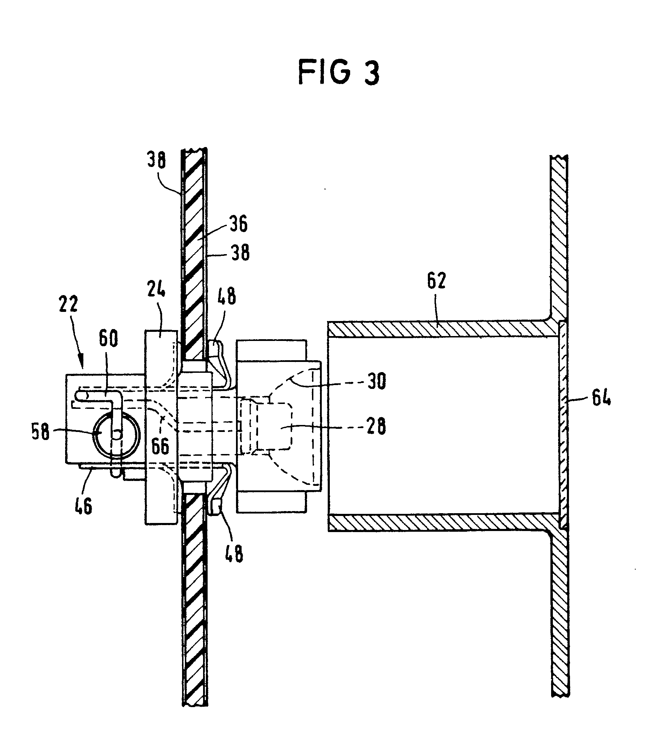

Figure 3 is a partly sectional side view of the operative position illustrated in Figure 2. Figure 3 further shows a hood 62 with a diffuser screen 64. It includes a symbol of the described kind, which is to be lit by the light emitting diode 28. In a procedure which is not part of the present invention, the hood 62 is pushed on to the diode holder 26 until it approximately comes to bear against the printed circuit board 36, over the former, and fixed in position. When that is done, the spacing between the light emitting diode 28 and the diffuser screen 64 can also be set to a desired spacing. That further influences the illumination of the diffuser screen 64.

Figure 4 is a view in longitudinal section of the components already referred to above. In addition Figure 4 shows a connecting wire 66 of the light emitting diode 28. A further connecting wire is disposed behind the plane of the drawing. The visible connecting wire 66 is bent. Figure 4 further shows an aperture 68 which extends in the longitudinal direction of the housing 24 and which accommodates the connecting wire 66. The shape of the aperture 68 is matched to the bent configuration of the connecting wire 66. That means that the light emitting diode 28 can be fitted into the housing 24 only in one rotary position. The connecting wire 66 which can be seen in Figure 4 is connected to a connecting wire 60 of the resistor 58. The further connecting wire 60 of the resistor 58 is connected to the contact bar which is at the bottom in Figure 4.

Figure 5 shows a coding bar 34 in solid lines. Three further coding bars are indicated by dash-dotted lines.

Figure 6 shows the resistor 58 which is disposed behind the plane of the drawing, and its two connecting wires 60. The upwardly disposed connecting wire 60 is connected to the connecting wire 66 of the light emitting diode 28. The downwardly disposed connecting wire 60 of the resistor 58 is connected to a contact bar 46. Figure 6 further shows the direction of rotary movement in which the housing 24 is turned to latch it in the opening 40 in the printed circuit board 36. The connection between a connecting wire 60 and a connecting wire 66 is indicated in the form of a soldered connection 70. The connection between a connecting wire 66 of the light emitting diode 28 and a contact bar 46 is indicated at 72.

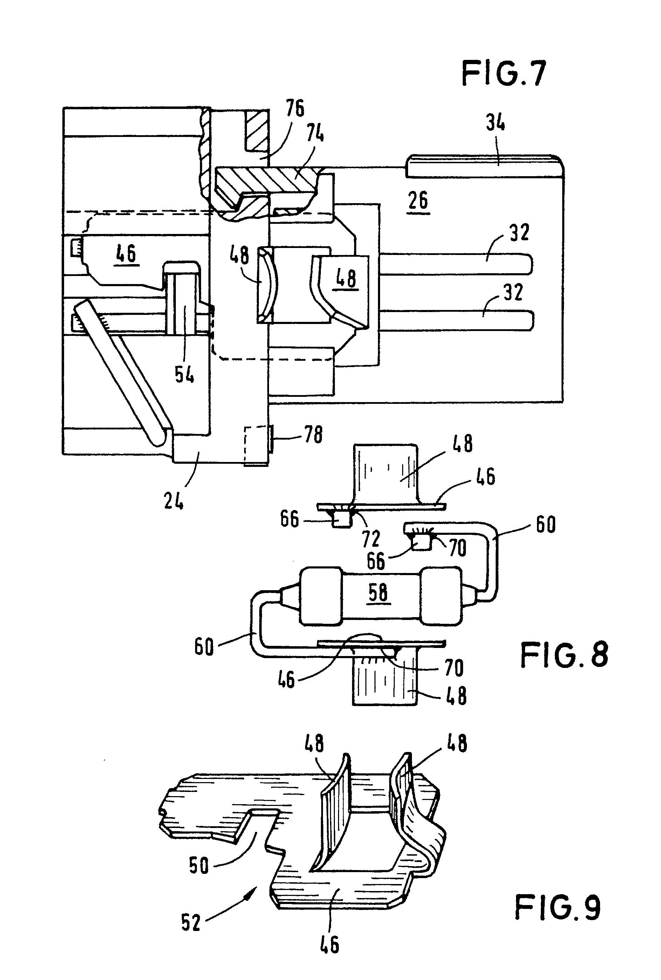

Figure 7 shows the connection between the diode holder 26 and the housing 24. The diode holder 26 has two resilient retaining hooks 74 which engage into recesses 76 in the housing 24. A retaining hook 74 and a recess 76 can be seen in Figure 7. Figure 7 further shows the resilient retaining projection 78 on the face of the housing 24 which is towards the printed circuit board 76 which is not shown in Figure 7. The retaining projection 78 has an inclined surface and prevens excessive rotary movement, when the housing 24 is rotated in the manner shown in Figure 2.

Figure 8 shows in detail the resistor 58 with its two connecting wires 60. The upwardly disposed connecting wire 60 is connected to a connecting wire 66 of the light emitting diode 28. The downwardly disposed connecting wire 60 is directly connected to a contact bar 46. Figure 8 further shows the other connecting wire 66 of the light emitting diode 28, which is connected to the other contact bar 46.

Figure 9 is a perspective view of a contact 52 which is a stamped member. The contact 52 comprises the contact bar 56 with the opening 50 and the two contact legs 48 which are bent away through about 90°.

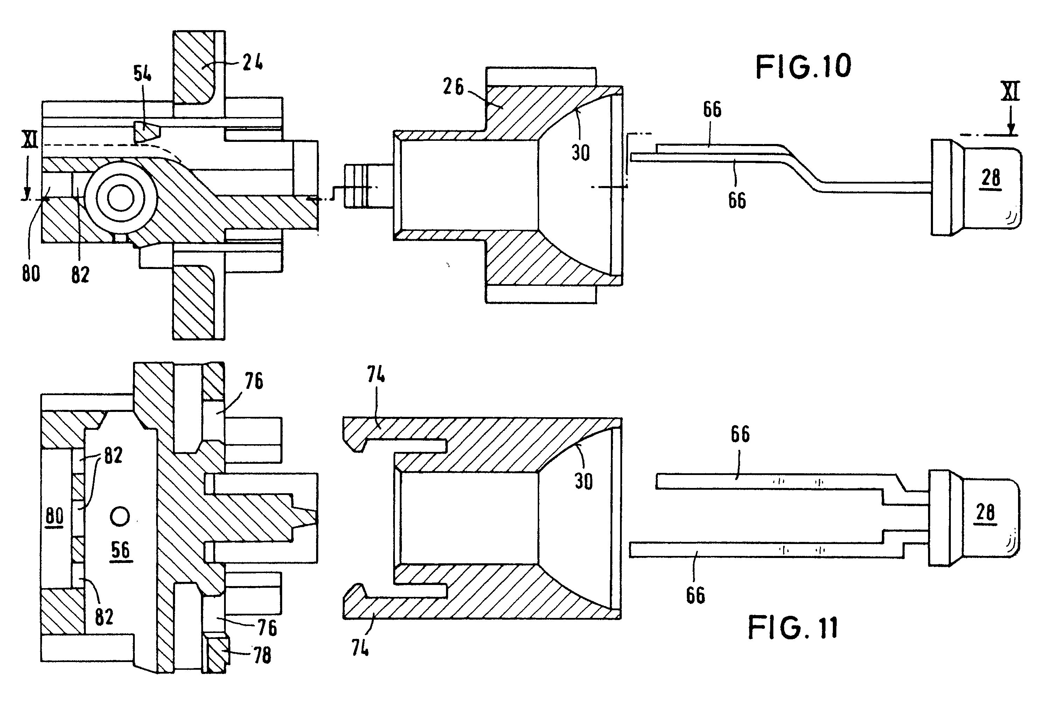

Figures 10 and 11 illustrate the mechanical connection of the light emitting diode 28, the diode holder 26 and the housing 24. Figures 10 and 11 show the bent configuration, as already referred to above, of the two connecting wires 66 of the light emitting diode 28. For connecting the parts together, the diode holder 26 is displaced towards the left, when looking at Figures 10 and 11. When that is done, the two retaining hooks 74 pass into the recesses 76. In the operative position the retaining hooks 74 engage behind the wall forming the recesses 76 and bear resiliently against the inward side thereof. In addition the light emitting diode 28 is pushed with its two connecting wires 66 through the diode holder 26 into the recesses 76 in the housing 24. Figures 10 and 11 further show a slot 80 in the face of the housing 24, which is illustrated on the left. Orifices 82 connect the slot 80 to the aperture 56 which accommodates the resistor 58. As already stated, a screwdriver can be fitted into the slot 80. That makes it easier to rotate the housing 24 in the opening 40 of the printed circuit board 36, into its definitive operative position.

## Claims

1. Holding and connecting device for a light emitting diode (LED) (28), for use thereof for illuminating for example a diffuser screen (64) provided with a symbol, comprising a diode holder (26) with a reflection surface (30), a light emitting diode (28) with connecting wires (66), and contacts for mechanical and electrical connection thereof to a printed circuit board (36), characterized in that there is provided a housing (24), the light emitting diode (28) is fitted into and connected to same, the contacts (52) are arranged on two mutually oppositely disposed sides of the housing (24), and the diode holder (26) is connected to the housing and can be fitted into an opening (40) in the printed circuit board (36) and on its outward side has a coding bar (34) which permits the diode holder (26) to be fitted into the opening (40) only in one rotary position of the diode holder (26).

2. Holding and connecting device according to claim 1, characterized in that the contacts (52) comprise a resilient material and the contact legs (48) are stamped and bent out of a contact bar (46) at a spacing from each other.

3. Holding and connecting device according to anyone of claims 1 and 2, characterized in that an opening (50) is provided in each contact bar (46) and limb portions (54) corresponding to the openings are provided on the outward side of the housing (24), and the limb portions (54) are disposed in a close fit in the openings (50).

4. Holding and connecting device according to anyone of claims 1 to 3, characterized in that the connecting wires (66) of the light emitting diode (28) are connected to a contact bar (46) and a connecting wire (60) of a resistor (58) inserted between the light emitting diode (28) and a contact (52) for connection to the printed circuit board (36).

5. Holding and connecting device according to anyone of claims 1 to 4, characterized in that provided in the housing (24) is an aperture (68) extending in the longitudinal direction thereof for accommodating the connecting wires (66) of the light emitting diode (28), and the shape thereof is so matched to that of the connecting wires (66) that the diode (28) can be fitted into the housing (24) only in one position.

6. Holding and connecting device according to anyone of claims 1 to 5, characterized in that arranged on the outward side of the diode holder (26) and extending in the longitudinal direction thereof are bar portions (32) which are aligned with the contact legs (48), wherein the bar portions (32) are arranged in pairs and two bar portions (32) are associated with each respective contact leg (48).

7. Holding and connecting device according to anyone of claims 1 to 6, characterized in that provided in the opening (40) in the printed circuit board (36), for accommodating the diode holder (26), are recesses (42) which are aligned with the bar portions (32) and which accommodate same.

8. Holding and connecting device according to anyone of claims 1 to 7, characterized in that a mounting opening (44) is provided at a given location at the edge of the opening (40) in the printed circuit board (36), which accommodates the diode holder (26), the given location is associated with a given colour in respect of a light emitting diode (28), and the position of the coding bar (34) on the outward side of the diode holder (26) is associated with the same colour and corresponds to the position of the mounting opening (44).

9. Holding and connecting device according to claim 8, characterized in that the housing (24) of a light emitting diode (28) is coloured with a colour corresponding to the colour of the light emitting diode (28).

10. Holding and connecting device according to anyone of claims 1 to 9, characterized in that retaining hooks (74) are provided on the end of the diode holder (26), which is towards the housing (24), and recesses (76) for accommodating the retaining hooks (74) are provided in the housing (24), the retaining hooks (74) and the recesses (76) being of different widths.

## FIG.1

## FIG.2

# FIG 3

FIG.4

FIG.5

FIG.6

FIG.7

FIG.8

FIG.9

FIG.10

FIG.11